# EUROPEAN PATENT APPLICATION

(11) **EP 3 869 920 A1**
(43) Date of publication of application: **25.08.2021**
(21) Application number: 21157879.4
(22) Date of filing: 18.02.2021
(51) Int. Cl.: H05B 6/12

(54) **INDUCTION HEATING TYPE COOKTOP HAVING IMPROVED USABILITY**

(30) Priority: 19.02.2020 KR 20200020694
(71) Applicant: LG Electronics Inc., Yeongdeungpo-gu Seoul 07336 (KR)
(72) Inventor: JANG, Eunjin, Seoul 08592 (KR); KIM, Wontae, Seoul 08592 (KR); KIM, Juwon, Seoul 08592 (KR); HWANG, Jongwon, Seoul 08592 (KR); KIM, Taeho, Seoul 08592 (KR); KIM, Taehee, Seoul 08592 (KR)
(74) Representative: Vossius & Partner Patentanwälte Rechtsanwälte mbB

(57) **Abstract**

An induction heating type cooktop includes: a case, a cover plate that is coupled to an upper end of the case and that includes an upper plate arranged to receive a target object, a working coil that is disposed in the case and that is configured to heat the target object, a heating module that is disposed at a lower surface of the upper plate of the cover plate and that includes an electrically conductive material, and a thermal insulation material disposed between the heating module and the working coil.

## Description

### TECHNICAL FIELD

The present disclosure relates to an induction heating type cooktop having improved usability.

### BACKGROUND

Various types of cooking apparatuses are used to heat food at homes or restaurants. Among the cooking apparatuses, a gas stove can use gas as fuel to heat the food. In recent years, cooking apparatuses, capable of using electricity to heat an object to be heated, such as a cooking vessel including a pot, have been widely used instead of the gas stoves.

Methods for heating an object to be heated using electricity can be classified as a resistance heating method and an induction heating method. In the resistance heating method, an object to be heated is heated by heat that is generated when electric current flows through (i) a metallic resistance wire or (ii) a non-metallic heat generating element such as silicon carbide, and the generated heat is delivered to the object to be heated (e.g., a cooking vessel) through radiation or conduction. In the induction heating method, an object to be heated can be heated by eddy current that is generated in the object including metallic ingredients, by using a magnetic field that is generated around a coil when a predetermined magnitude of high-frequency power is supplied to the coil.

In recent years, the induction heating method has been applied to most cooktops.

A cooktop to which the induction heating method is applied can only heat a magnetic object. For example, when a non-magnetic object (e.g., thermal resistant glass, earthenware and the like) is placed on the cooktop, the cooktop cannot heat the object to be heated.

Accordingly, the following methods and cooktops have been developed to overcome limitations of an induction heating type cooktop of the related art.

First, a method of adding a heating plate, which can be heated based on induction heating, between a cooktop and a non-magnetic object has been devised in order to heat the non-magnetic object. However, for the cooktop with additional heating plate, efficient heating cannot be ensured and required time to boil water can be longer than usual. Additionally, a cooking vessel including a magnetic material is heated in an electro inductive manner using magnetic lines of force that passes through the communication hole while the heating plate is heated in an electro inductive manner using a heating coil. Thus, efficient heating cannot be ensured.

Second, a conventional cooktop can include a hybrid cooktop that heats a non-magnetic object through a radiant heater to which an electric resistance method is applied and that heats a magnetic object through a working coil to which an induction heating method is applied. However, for the hybrid cooktop, a high output from the radiant heater and efficient heating cannot be ensured. Additionally, when placing an object to be heated in a heating area, a user needs to consider a material of the object to be heated.

Finally, a conventional cooktop can include an all metal cooktop that heats all metallic objects to be heated (i.e., a non-magnetic metallic object and a magnetic metallic object). However, for the all metal cooktop, a non-magnetic non-metallic object to be heated cannot be heated. When a non-magnetic metallic object to be heated is heated, the all metal cooktop is less efficient in heating and incurs more material costs than a radiant heater.

### SUMMARY

The present disclosure is directed to an induction heating type cooktop that can heat a target object regardless of a type of the target object and that can ensure improved heating efficiency.

The present disclosure is also directed to an induction heating type cooktop that can heat both the magnetic object and non-magnetic object without causing a user to consider a material of the target object.

The present disclosure is also directed to an induction heating type cooktop that can heat a target object directly and indirectly using the same heat source.

The present disclosure is also directed to an induction heating type cooktop in which (i) when a target object has a magnetic property, most of the eddy current can be supplied to the target object and a working coil can directly heat the target object and (ii) when a target object has a non-magnetic property, the working coil can indirectly heat the object to be heated.

The present disclosure is also directed to an induction heating type cooktop in which a component allowing an induction heating can be manufactured in a simple manner and processing costs can be reduced.

According to one aspect of the subject matter described in this application, an induction heating type cooktop includes a case, a cover plate that is coupled to an upper end of the case and that includes an upper plate arranged to receive a target object, a working coil that is disposed in the case and that is configured to heat the target object, a heating module that is disposed at a lower surface of the upper plate of the cover plate and that includes an electrically conductive material, and a thermal insulation material disposed between the heating module and the working coil.

Implementations according to this aspect can include one or more of the following features. For example, the electrically conductive material can comprise at least one of metal, a conductive oxide, a conductive polymer, or a carbon-based material.

In some examples, the electrically conductive material can comprise metal and the metal can comprise at least one of aluminum (Al), copper (Cu), titanium (Ti), nickel (Ni), silver (Ag), gold (Au), platinum (Pt), palladium (Pd), beryllium (Be), rhodium (Rh), iridium (Ir), iron (Fe), molybdenum (Mo), or tungsten (W). In some implementations, the metal can comprise Ag. In some implementations, the metal can comprise (i) 0.1 to 90 wt% of Ag and (ii) a remaining part that includes at least one of Cu or Al.

In some examples, the electrically conductive material can comprise the conductive oxide and the conductive oxide can comprise at least one of indium tin oxide (ITO), zinc oxide (ZnO), tin oxide (SnO2), titanium dioxide (TiO2), Ga-doped ZnO (GZO), or Al-doped ZnO (AZO). In some examples, the electrically conductive material can comprise the conductive polymer and the conductive polymer can comprise at least one of poly 3,4-ethylenedioxythiophene (PEDOT) or polystyrene sulfonate (PSS).

In some implementations, the electrically conductive material can comprise the carbon-based material and the carbon-based material can comprise at least one of graphite, graphene, a carbon nanotube (CNT), a carbon nanofiber, carbon black, or activated carbon.

In some implementations, the electrically conductive material can comprise the carbon-based material, and the heating module can comprise an oxidation prevention layer on at least one surface of the heating module. In some examples, the oxidation prevention layer can comprise at least one of an inorganic material or a metal oxide.

In some implementations, the heating module can be an individual heating module part made of the electrically conductive material.

In some implementations, a skin depth of the heating module can be greater than a thickness of the heating module. In some examples, the heating module can have (i) a thickness of 2 mm or less and (ii) a resistance value that enables the heating module to be heated by the working coil.

In some implementations, a diameter of the heating module can be shorter than a diameter of the upper plate.

In some implementations, based on the target object being magnetic, resistance and inductance of the target object can provide an equivalent circuit with resistance and inductance of the heating module. In some examples, impedance of the target object can be less than impedance of the heating module in the equivalent circuit. In some examples, magnitude of eddy current supplied to the target object can be greater than magnitude of eddy current supplied to the heating module.

In some implementations, based on the target object being non-magnetic, impedance can be present in the heating module and impedance does not present in the target object. In some examples, eddy current can be supplied to the heating module, and eddy current is not supplied to the target object.

In some implementations, based on the target object being magnetic, the target object can be directly heated by the working coil, and based on the target object being non-magnetic, the target object can be heated by the heating module that is heated by the working coil. In some implementations, the induction heating type cooktop can further include a blocking plate that is disposed at a lower surface of the working coil and that is configured to block a magnetic field generated downward by the working coil, a support member that is disposed between a lower surface of the blocking plate and a lower surface of the case and that supports the blocking plate, and a cooling fan that is disposed in the case and that is configured to cool the working coil.

In some examples, the support member can comprise an elastic object for supporting the blocking plate upward. In some implementations, the cooling fan can be configured to (i) suction air from outside of the case and deliver the suctioned air to the working coil or (ii) suction air in the case and discharge the suctioned air to outside of the case, and the thermal insulation material can limit delivery of heat to the working coil.

The induction heating type cooktop can heat all the magnetic and non-magnetic objects. Additionally, the induction heating type cooktop can heat a target object regardless of a position and type of the target object. Thus, a user may place and heat a target object in any heating area on the upper plate without verifying whether the target object has a magnetic or non-magnetic property.

Additionally, the induction heating type cooktop can use the same heat source to heat a target object directly and indirectly. Accordingly, the induction heating type cooktop does not require an additional heating plate or radiant heater. Thus, the induction heating type cooktop can improve heating efficiency and reduce material costs.

Further, unlike a cooktop in which a component related to heating is directly coated on an upper plate, the induction heating type cooktop can ensure improvement in productivity and mass production since a size of a coating facility and processing costs are reduced.

### BRIEF DESCRIPTION OF THE DRAWINGS

FIG. 1 is a diagram illustrating an exemplary induction heating type cooktop.
FIG. 2 is a diagram illustrating components included in the exemplary induction heating type cooktop in FIG. 1.
FIGS. 3 and 4 are diagrams illustrating views for describing a relationship between thickness and skin depth of a heating module.
FIGS. 5 and 6 are diagrams illustrating views for describing a change in impedance between a heating module and a target object based on a type of the target object.
FIG. 7 is a diagram illustrating an exemplary induction heating type cooktop.
FIG. 8 is a diagram illustrating components included in the exemplary induction heating type cooktop in FIG. 7.
FIG. 9 is a diagram illustrating a view of a state in which target objects are placed on the exemplary induction heating type cooktop in FIG. 7.

### DETAILED DESCRIPTION

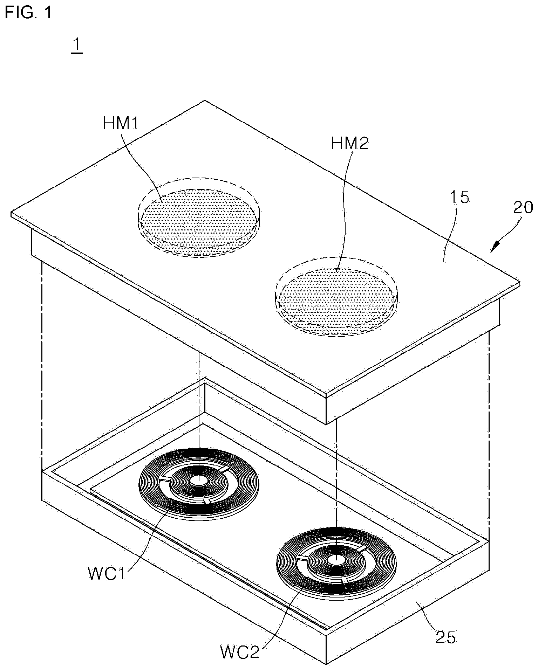

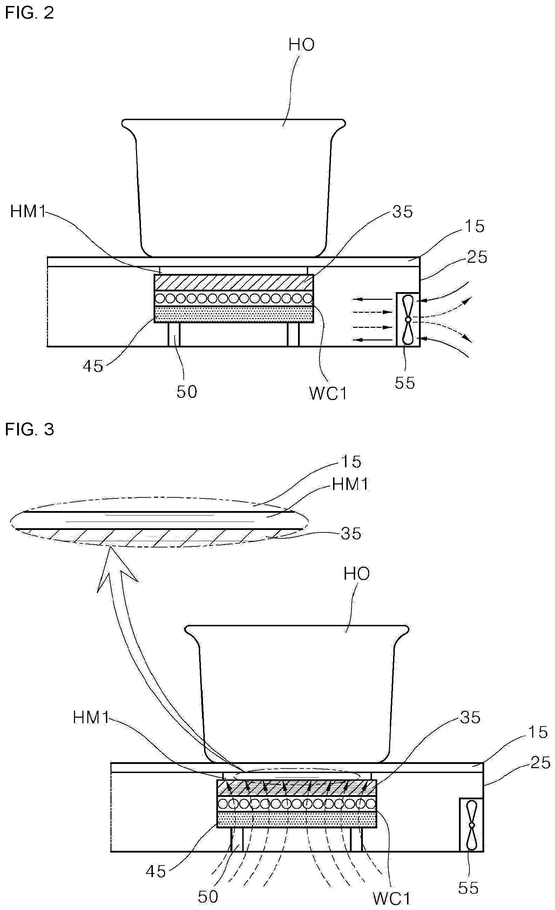

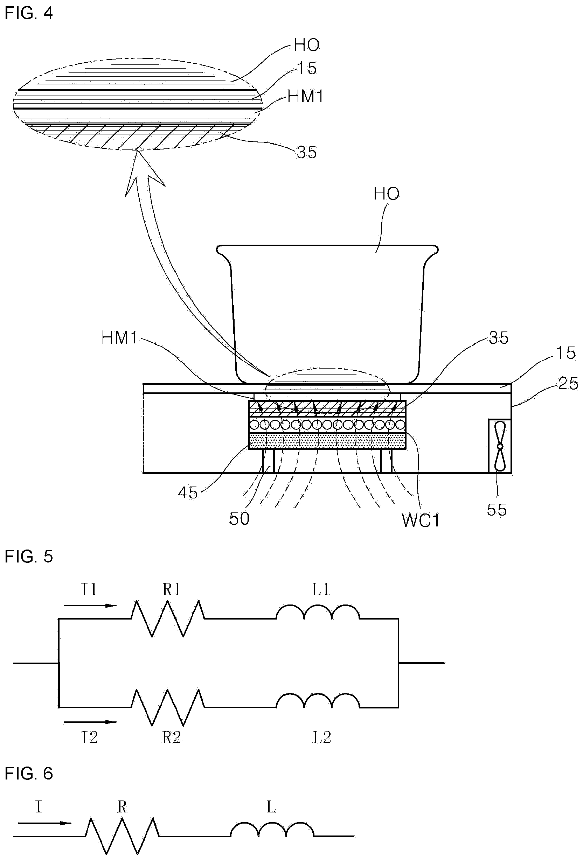

FIG. 1 is a diagram illustrating an exemplary induction heating type cooktop. FIG. 2 is a diagram illustrating components included in the exemplary induction heating type cooktop in FIG. 1. FIGS. 3 and 4 are diagrams illustrating views for describing features of skin depth based on relative permeability of a heating module. FIGS. 5 and 6 are diagrams illustrating views for describing a change in impedance between a heating module and a target object based on a type of the target object.

Referring to FIG. 1, an induction heating type cooktop 1 can include a case 25, a cover plate 20, working coils WC1 and WC2 (i.e., first and second working coils), and heating modules HM1 and HM2 (i.e., first and second heating modules).

The working coils WC1 and WC2 can be installed in the case 25.

In the case 25, various types of devices related to driving the working coils WC1 and WC2, in addition to the working coils WC1 and WC2 can be installed. The devices, for example, can include a power supply configured to supply AC power, a rectifier configured to rectify AC power of the power supply into DC power, an inverter configured to convert DC power, rectified by the rectifier, into resonance current as a result of a switching operation and supply the resonance current to the working coils, a control module-the control module can include a control module for an inverter configured to control a switching operation of an inverter and a control module for an input interface configured to control an input interface-configured to control operations of various devices in the induction heating type cooktop 1, a relay or a semiconductor switch configured to turn on or turn off the working coils, and the like.

The cover plate 20 can be coupled to an upper end of the case 25, and can be provided with an upper plate 15 that allows a target object to be placed on an upper surface thereof.

For example, the cover plate 20 can include the upper plate 15 for placing a target object such as a cooking vessel.

The upper plate 15, for example, can be made of a glass material (e.g., ceramics glass).

The upper plate 15 can be provided with an input interface configured to receive an input from a user and deliver the input to the control module. In some implementations, the input interface can be disposed at another position in the induction heating type cooktop 1.

The input interface can be a module for inputting heating intensity or a time period of driving of the induction heating type cooktop 1 and similar features desired by the user, and can be implemented in various different forms such as a physical button or a touch panel and the like. In addition or alternatively, the input interface can be provided with a power button, a lock button, a power level adjustment button (+, -), a timer adjustment button (+, -), a charge mode button and the like. Further, the input interface can deliver an input, received from the user, to the control module for an input interface, and the control module for an input interface can deliver the input to the control module for an inverter. The control module for an inverter can control an operation of various devices (e.g., a working coil) based on the input (i.e., the user's input) received from the control module for an input interface.

The upper plate 15 can visually display whether the working coil (e.g., the first working coil and the second working coil WC1 and WC2) is driving, and heating intensity (i.e., thermal power) of the working coil, in a burner shape. The burner shape can be displayed by an indicator including a plurality of light emitting elements (e.g., LEDs) in the case 25.

The first and second working coils WC1 and WC2 can be installed in the case 25 to heat a target object.

For example, driving of the first and second working coils WC1 and WC2 can be controlled by the control module for an inverter, and when a target object is placed on the upper palte15, the first and second working coils WC1 and WC2 can be driven by the control module for an inverter.

In some implementations, the first and second working coils WC1 and WC2 can directly heat a target object (i.e., a magnetic object) having a magnetic property, and first and second heating modules HM1 and HM2 can indirectly heat a target object (i.e., a non-magnetic object) having no magnetic property.

In some implementations, the first and second working coils WC1 and WC2 can inductively heat a target object, and can be respectively disposed to overlap the first and second heating modules HM1 and HM2 in a vertical direction (i.e., a perpendicular direction or an up-down direction).

In FIG. 1, two working coils WC1 and WC2 are installed in the case 25, however, in some implementations, one or three or more working coils can be installed in the case 25. The first and second working coils WC1 and WC2 installed in the case 25 will be described as an example for convenience of description.

A heating module can include first and second heating modules HM1 and HM2, and each of the first and second heating modules HM1 and HM2 can be spaced from each other and disposed on a lower surface of the upper plate 15.

The first and second heating modules HM1 and HM2 can be respectively disposed to overlap the first and second working coils WC1 and WC2 in a vertical direction (i.e., a perpendicular direction or an up-down direction).

In some implementations, the first and second heating modules HM1 and HM2 can have at least one of a magnetic property or a non-magnetic property (i.e., a magnetic property, a non-magnetic property or both of the magnetic and non-magnetic properties).

The first and second heating modules HM1 and HM2 can have a variety of shapes. In some implementations, the first and second heating modules HM1 and HM2 can have a thin plate shape.

The first and second heating modules HM1 and HM2 can include an electrically conductive material. The electrically conductive material can include all materials that conduct electricity. For example, the electrically conductive material can include one or more of metal, a conductive oxide, a conductive polymer, and a carbon-based material.

As described above, the electrically conductive material can include metal. For example, the metal can include one or more of aluminum (Al), copper (Cu), titanium (Ti), nickel (Ni), silver (Ag), gold (Au), platinum (Pt), palladium (Pd), beryllium (Be), rhodium (Rh), iridium (Ir), iron (Fe), molybdenum (Mo) or tungsten (W). Skin depth of the heating module HM1 can be greater than thickness of the heating module HM1. The heating module HM1 can be made of a material having a relatively high electrical conductivity and a low resistivity. In some implementations, the heating module HM1 can be made of Ag (silver). For example, the heating module HM1 can include 0.1 to 90 wt% (percentage by weight) of Ag, and a remaining part including one or more of Cu and Al, excluding a metallic material having a relatively high resistance. In some implementations, Cu and Al having high electrical conductivity and low resistivity can be partially used.

The conductive material can include a conductive oxide. The conductive oxide can include all the oxides such as a metal oxide, a transition metal oxide and the like having an electrically conductive property. For example, the conductive oxide can include one or more of indium tin oxide (ITO), zinc oxide (ZnO), tin oxide (SnO₂), titanium dioxide (TiO2), Ga-doped ZnO (GZO), and Al-doped ZnO (AZO).

The conductive material can include a conductive polymer. For example, the conductive polymer can include all the polymers having an electrically conductive property. By way of further example, the conductive polymer can include one or more of poly 3,4-ethylenedioxythiophene (PEDOT) and polystyrene sulfonate (PSS).

The conductive material can include a carbon-based material. For example, the carbon-based material can include all the carbon-based materials having an electrically conductive property. By way of further example, the carbon-based material can include one or more of graphite, graphene, a carbon nanotube (CNT), a carbon nanofiber, carbon black and activated carbon.

When the heating module HM1 includes a carbon-based material, the heating module HM1 can include an oxidation prevention layer on at least one surface thereof. When heat is applied to a carbon-based material, oxidation of the carbon-based material may not be avoided. Accordingly, a proper oxidation prevention layer, that includes one or more of an inorganic material and a metal oxide, may be required. For example, the oxidation prevention layer can include glass material such as silicon dioxide (SiO₂) and boron trioxide (B₂O₃). The oxidation prevention layer can have a thickness of 1 µm or greater to block air infiltration and moisture infiltration. In some implementations, the oxidation prevention layer can have a thickness of 150 µm or less to delivery heat. If the heating module HM1 contacts the upper place, heat can be readily delivered. Accordingly, the thickness of the oxidation prevention layer may exceed 150 µm.

The form of the heating module HM1 may vary. The heating module HM1 can be formed into an individual heating module part including the above electrically conductive materials. For example, the heating module HM1 can be formed into a thin plate made of the above electrically conductive materials. Accordingly, the heating module HM1 having a simple structure can produce an effect of induction heating.

The first and second heating modules HM1 and HM2 can have a thickness to such an extent that the first and second heating modules HM1 and HM2 are inductively heated by the working coils.

A diameter (i.e., a size) of each of the first and second heating modules HM1 and HM2 can be less than a diameter of the upper plate 15.

Referring to FIG. 2, the induction heating type cooktop 1 can further include a thermal insulation material 35, a blocking plate 45, a support member 50, and a cooling fan 55.

Since components around the first working coil WC1 are the same as those around the second working coil (WC2 in FIG.1), the components (the first heating module HM1, the thermal insulation material 35, the blocking plate 45, the support member 50 and the cooling fan 55) around the first working coil WC1 are described below for convenience of description.

The thermal insulation material 35 can be disposed between the first heating module HM1 and the first working coil WC1.

The thermal insulation material 35 can block delivery of heat, which is generated while the first heating module HM1 or a target object HO is heated as a result of the driving of the first working coil WC1, to the first working coil WC1.

For example, when the first heating module HM1 or a target object HO is heated based on electromagnetic induction of the first working coil WC1, heat of the first heating module HM1 or the target object HO may be delivered to the upper plate 15, and heat of the upper plate 15 may be delivered to the first working coil WC1. Accordingly, the first working coil WC1 may be damaged.

The thermal insulation material 35, as described above, can block delivery of heat to the first working coil WC1, limit damage done to the first working coil WC1 by heat, and limit deterioration of the heating performance of the first working coil WC1.

In some implementations, the spacer can be installed between the first working coil WC1 and the thermal insulation material 35.

The spacer can be inserted between the first working coil WC1 and the thermal insulation material 35 such that the first working coil WC1 and the thermal insulation material 35 do not directly contact each other. Accordingly, the spacer can block delivery of heat, which is generated while the first heating module HM1 or a target object HO is heated as a result of the driving of the first working coil WC1, to the first working coil WC1 through the thermal insulation material 35.

Since the spacer shares a role of the thermal insulation material 35, the thickness of the thermal insulation material 35 can be minimized. Thus, a gap between the target object HO and the first working coil WC1 can be minimized.

In some implementations, a plurality of spacers can be provided and can be spaced apart from each other between the first working coil WC1 and the thermal insulation material 35. Accordingly, air suctioned into the case 25 by a cooling fan 55 described below can be guided to the first working coil WC1 by the spacer.

For example, the spacer can guide air, suctioned into the case 25 by the cooling fan 55, to the first working coil WC1 properly to improve cooling efficiency of the first working coil WC1.

The blocking plate 45 can be disposed on a lower surface of the first working coil WC1 and can block a magnetic field that is generated downward when the first working coil WC1 is driven.

For example, the blocking plate 45 can block a magnetic field that is generated downward when the first working coil WC1 is driven, and can be supported upward by the support member 50.

The support member 50 can be installed between a lower surface of the blocking plate 45 and a lower surface of the case 25 and can support the blocking plate 45 upward.

The support member 50 can indirectly support the first working coil WC1, the thermal insulation material 35 and the first heating module HM1 upward by supporting the blocking plate 45 upward. Accordingly, a gap between the first working coil WC1 and a target object HO can remain constant.

In some implementations, the support member 50 can include an elastic object (e.g., a spring) for supporting the blocking plate 45 upward. In some implementations, the induction heating type cooktop 1 may not include the support member 50.

The cooling fan 55 can be installed in the case 25 to cool the first working coil WC1.

For example, driving of the cooling fan 55 can be controlled by the above-described control module, and can be disposed on a lateral wall of the case 25. In some implementations, the cooling fan 55 can be disposed at another position instead of a lateral wall of the case 25. The cooling fan 55 disposed on a lateral wall of the case 25 will be described as an example for convenience of description.

The cooling fan 55, as illustrated in FIG. 2, can suction air outside the case 25 and deliver the air to the first working coil WC1, or can suction air (in particular, hot air) in the case 25 and discharge the air out of the case 25.

Thus, components (in particular, the first working coil WC1) in the case 25 can be efficiently cooled.

The air outside the case 25, delivered to the first working coil WC1 by the cooling fan 55, can be guided to the first working coil WC1 by the spacer. Accordingly, the first working coil WC1 can be cooled directly and efficiently, and durability (i.e., durability as a result of prevention of damage caused by heat) of the first working coil WC1 can improve.

The induction heating type cooktop 1 can have the above features and configurations. Referring to FIGS. 3 to 6, features and configurations of the above-described heating module will be described.

Further, thickness of each component illustrated in FIGS. 3 and 4 is schematically expressed for convenience of description and does not relate to an actual scale, and a difference between relative thicknesses of the components do not relate to an actual scale.

FIGS. 3 and 4 are diagrams illustrating views for describing a relationship between thickness and skin depth of a heating module. FIGS. 5 and 6 are diagrams illustrating views for describing a change in impedance between a heating module and a target object based on a type of the target object.

The first heating module HM1 and the second heating module HM2 can have the same technical features. For convenience of description, the first heating module HM1 will be described below as an example.

The features of the first heating module HM1 are described as follows.

The first heating module HM1 can be made of a material having a low relative permeability. Types of the material are described above.

For example, the relative permeability of the first heating module HM1 can be low and the skin depth of the first heating module HM1 can be deep. The skin depth can denote a depth to which electric current permeates from a surface of a material, and the relative permeability can be inversely proportional to the skin depth. Accordingly, as the relative permeability of the first heating module HM1 becomes low, the skin depth of the first heating module HM1 can become deep.

Additionally, the skin depth of the first heating module HM1 can be greater than the thickness of the first heating module HM1. For example, since the first heating module HM1 has a small thickness and has a skin depth greater than the thickness thereof, a magnetic field generated by the first working coil WC1 can pass through the first heating module HM1 and can be delivered to the target object HO, such that eddy current is induced to the target object HO.

The first heating module HM1 can have a thickness of 2 mm or less, for example, and a resistance value to such an extent that the first heating module HM1 can be heated by the working coil.

When the skin depth of the first heating module HM1 is less than the thickness of the first heating module HM1, as illustrated in FIG. 3, a magnetic field generated by the first working coil WC1 can hardly reach the target object HO.

When the skin depth of the first heating module HM1 is greater than the thickness of the first heating module HM1, as illustrated in FIG. 4, a magnetic field generated by the first working coil WC1 can mostly reach the target object HO. For example, since the skin depth of the first heating module HM1 is greater than the thickness of the first heating module HM1, a magnetic field generated by the first working coil WC1 can pass through the first heating module HM1 and can be mostly used by the target object HO. Thus, the target object HO can be mainly heated.

The first heating module HM1 can have a small thickness as described above. Accordingly, the first heating module HM1 can have a resistance value to the extent that the first heating module HM1 can be heated by the first working coil WC1.

The thickness of the first heating module HM1 can be inversely proportional to the resistance value (i.e., a surface resistance value) of the first heating module HM1. For example, as the thickness of the first heating module HM1 becomes small, the resistance value (i.e., a surface resistance value) of the first heating module HM1 can become high.

Since the first heating module HM1 having the above features is provided to heat a non-magnetic object, an impedance feature between the first heating module HM1 and the target object HO can vary depending on whether the target object HO disposed on the upper surface of the upper plate 15 has a magnetic or non-magnetic property.

A case in which the target object has a magnetic property is described below.

Referring to FIGS. 2 and 5, when a magnetic target object HO is placed on the upper surface of the upper plate 15 and the first working coil WC1 is driven, resistance R1 and inductance L1 of the magnetic target object HO can form an equivalent circuit along with resistance R2 and inductance L2 of the first heating module HM1.

In some implementations, impedance (i.e., impedance including R1 and L1) of the magnetic target object can be less than impedance (i.e., impedance including R2 and L2) of the first heating module HM1, in the equivalent circuit.

When the above equivalent circuit is formed, magnitude of eddy current I1 supplied to the magnetic target object HO can be greater than magnitude of eddy current I2 supplied to the first heating module HM1. Accordingly, most of the eddy current can be supplied to the target object HO such that the target object HO is heated.

For example, when a target object HO has a magnetic property, the above equivalent circuit can be formed, and most of the eddy current can be supplied to the target object HO. Thus, the first working coil WC1 can directly heat the target object HO.

In some implementations, since some of the eddy current can be supplied to the first heating module HM1, the first heating module HM1 can be slightly heated. Accordingly, the target object HO can be indirectly and slightly heated by the first heating module HM1. However, a degree to which the target object HO is indirectly heated by the first heating module HM1 can be less significant than a degree to which the target object HO is directly heated by the first working coil WC1.

A case in which the target object has a non-magnetic property is described below.

Referring to FIGS. 2 and 6, when a non-magnetic target object HO is placed on the upper surface of the upper plate 15 and the first working coil WC1 is driven, impedance may not be present in the non-magnetic target object HO, and impedance can be present in the first heating module HM1. For example, resistance R and inductance L can be present only in the first heating module HM1.

Accordingly, eddy current I can be supplied only to the first heating module HM1 but not to the non-magnetic target object HO. For example, eddy current I can be supplied only to the first heating module HM1 such that the first heating module HM1 is heated.

In some implementations, when the target object HO has a non-magnetic property, eddy current I can be supplied to the first heating module HM1 to heat the first heating module HM1, and the non-magnetic target object HO can be indirectly heated by the first heating module HM1 heated by the first working coil WC1, as described above.

A protection temperature of the upper plate 15 can be preset by a manufacturer of an upper plate or a manufacturer of a cooktop. For example, a manufacturer of an upper plate may deliver information regarding a temperature-based lifespan of the upper plate to a manufacturer of a cooktop, and the manufacturer of a cooktop may calculate a lifespan of a product/the cooktop considering a length of time for which the cooktop is used and may set a protection temperature of the upper plate 15.

Further, a temperature sensor can be installed in one area of the upper plate 15, which can sense a change in temperatures of the upper plate 15 and supply information regarding the sensed temperature to the above-described control module.

As such, regardless of whether the target object HO has a magnetic or non-magnetic property, the target object HO can be heated directly and indirectly by a single heat source referred to as the first working coil WC1. For example, when the target object HO has a magnetic property, the first working coil WC1 can directly heat the target object HO, and when the target object HO has a non-magnetic property, the first heating module HM1 heated by the first working coil WC1 can indirectly heat the target object HO.

The induction heating type cooktop 1, as described above, can heat all the magnetic and non-magnetic objects. Accordingly, the induction heating type cooktop 1 can heat a target object regardless of the position and type of the target object. Thus, a user may place a target object in any heating area on the upper plate without checking whether the target object has a magnetic or non-magnetic property, and improved usability can be ensured.

Additionally, the induction heating type cooktop 1 can use the same heat source to heat a target object directly and indirectly. Accordingly, the induction heating type cooktop 1 requires no additional heating plate or radiant heater. Thus, the induction heating type cooktop 1 can improve heating efficiency and to reduce material costs.

Further, unlike a cooktop in which a heating module is directly coated on an upper plate, the induction heating type cooktop 1 can ensure improvement in productivity and mass production since the size of a coating facility and costs incurred for processing are reduced.

Another exemplary induction heating type cooktop is described below.

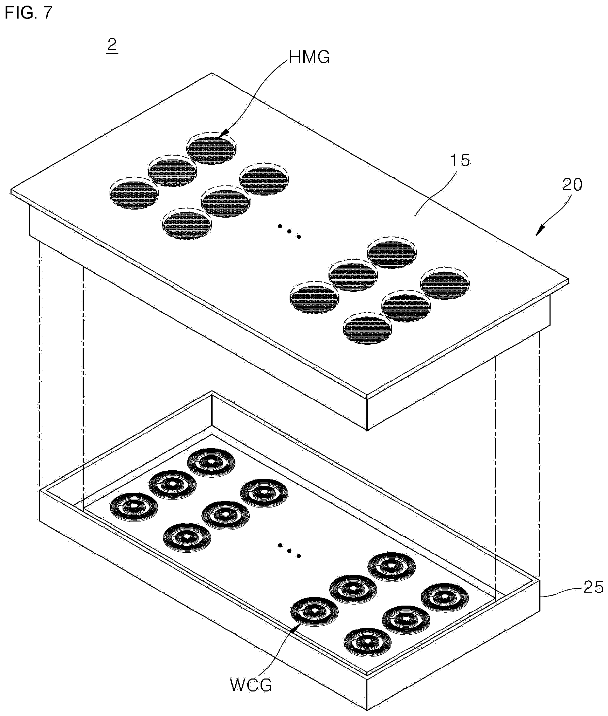

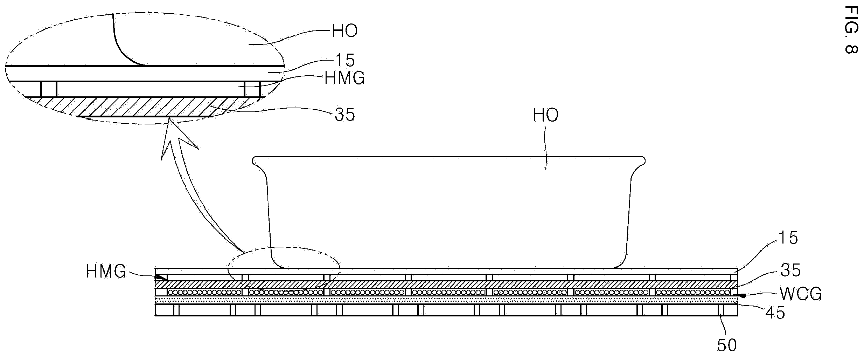

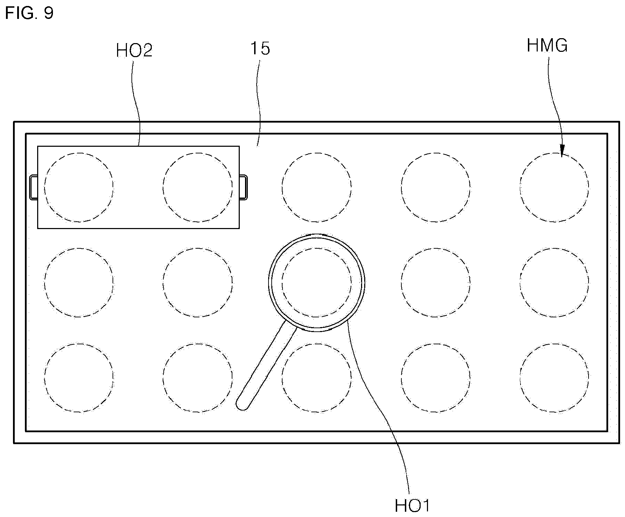

FIG. 7 is a diagram illustrating an exemplary induction heating type cooktop 2. FIG. 8 is a diagram illustrating components included in the induction heating type cooktop 2 in FIG. 7. FIG. 9 is a diagram illustrating a state in which target objects are placed on the induction heating type cooktop 2 in FIG. 7.

The induction heating type cooktop 2 can be the similar to the induction heating type cooktop 1 in FIG. 1 except for some components and effects, thus, the differences will be described below.

Referring to FIGS. 7 and 8, the induction heating type cooktop 2 can be a zone free type cooktop unlike the induction heating type cooktop 1 in FIG. 1.

The induction heating type cooktop 2 can include a case 25, a cover plate 20, a plurality of heating modules HMG, a thermal insulation material 35, a plurality of working coils WCG, a blocking plate 45, a support member 50, a cooling fan, a spacer, and a control module.

The plurality of heating modules HMG can overlap the plurality of working coils WCG in the vertical direction and can be disposed to respectively correspond to the plurality of working coils WCG on a one-to-one basis.

In some implementations, the plurality of heating modules HMG can correspond to the plurality of working coils WCG on a one-to-many basis instead of a one-to-one basis. The plurality of heating modules HMG disposed to correspond to the plurality of working coils WCG on a one-to-one basis is described as an example for convenience of description.

The induction heating type cooktop 2 can be a zone free type cooktop including the plurality of heating modules HMG and the plurality of working coils WCG. Accordingly, the cooktop 2 can heat a single target object HO using some or all of the plurality of working coils WCG or some or all of the plurality of heating modules HMG at the same time. In some implementations, the cooktop 2 can heat a target object HO using some or all of the plurality of working coils WCG and some or all of the plurality of heating modules HMG.

Thus, as illustrated in FIG. 9, target objects H01 and HO2 can be heated in an area (e.g., the upper plate 15 area) where the plurality of working coils (WCG in FIG. 8) and the plurality of heating modules HMG are provided, regardless of the positions, sizes and types of the target objects H01 and HO2.

## Claims

1. An induction heating type cooktop (1), comprising:
a case (25);
a cover plate (20) that is coupled to an upper end of the case (25) and that includes an upper plate (15) arranged to receive a target object (HO);
a working coil (WC1, WC2) that is disposed in the case (25) and that is configured to heat the target object (HO);
a heating module (HM1, HM2) that is disposed at a lower surface of the upper plate (15) and that includes an electrically conductive material; and
a thermal insulation material (35) disposed between the heating module (HM1, HM2) and the working coil (WC1, WC2).

2. The induction heating type cooktop of claim 1, wherein the electrically conductive material comprises at least one of metal, a conductive oxide, a conductive polymer, or a carbon-based material.

3. The induction heating type cooktop of claim 2, wherein the electrically conductive material comprises metal and the metal comprises at least one of aluminum (Al), copper (Cu), titanium (Ti), nickel (Ni), silver (Ag), gold (Au), platinum (Pt), palladium (Pd), beryllium (Be), rhodium (Rh), iridium (Ir), iron (Fe), molybdenum (Mo), or tungsten (W).

4. The induction heating type cooktop of claim 3, wherein the metal comprises Ag.

5. The induction heating type cooktop of claim 3, wherein the metal comprises (i) 0.1 to 90 wt% of Ag and (ii) a remaining part that includes at least one of Cu or Al.

6. The induction heating type cooktop of claim 2, wherein the electrically conductive material comprises the conductive oxide and the conductive oxide comprises at least one of indium tin oxide (ITO), zinc oxide (ZnO), tin oxide (SnO₂), titanium dioxide (TiO2), Ga-doped ZnO (GZO), or Al-doped ZnO (AZO).

7. The induction heating type cooktop of claim 2, wherein the electrically conductive material comprises the conductive polymer and the conductive polymer comprises at least one of poly 3,4-ethylenedioxythiophene (PEDOT) or polystyrene sulfonate (PSS).

8. The induction heating type cooktop of claim 2, wherein the electrically conductive material comprises the carbon-based material and the carbon-based material comprises at least one of graphite, graphene, a carbon nanotube (CNT), a carbon nanofiber, carbon black, or activated carbon.

9. The induction heating type cooktop of claim 2, wherein the electrically conductive material comprises the carbon-based material, and the heating module (HM1, HM2) comprises an oxidation prevention layer on at least one surface of the heating module (HM1, HM2).

10. The induction heating type cooktop of claim 9, wherein the oxidation prevention layer comprises at least one of an inorganic material or a metal oxide.

11. The induction heating type cooktop of any one of claims 1 to 10, wherein the heating module (HM1, HM2) is an individual heating module part made of the electrically conductive material.

12. The induction heating type cooktop of any one of claims 1 to 11, wherein a skin depth of the heating module (HM1, HM2) is greater than a thickness of the heating module (HM1, HM2).

13. The induction heating type cooktop of any one of claims 1 to 12, wherein, based on the target object (HO) being magnetic, resistance and inductance of the target object (HO) provide an equivalent circuit with resistance and inductance of the heating module (HM1, HM2).

14. The induction heating type cooktop of any one of claims 1 to 13, wherein based on the target object (HO) being non-magnetic, impedance is present in the heating module (HM1, HM2) and impedance is not present in the target object (HO).

15. The induction heating type cooktop of any one of claims 1 to 14, further comprising:
a blocking plate (45) that is disposed at a lower surface of the working coil (WC1, WC2) and that is configured to block a magnetic field generated downward by the working coil (WC1, WC2);
a support member (50) that is disposed between a lower surface of the blocking plate (45) and a lower surface of the case (25) and that supports the blocking plate (45); and
a cooling fan (55) that is disposed in the case (25) and that is configured to cool the working coil (WC1, WC2).
